# NEUE EUROPÄISCHE PATENTSCHRIFT

(11) **EP 0 767 407 B2**
(45) Veröffentlichungstag und Bekanntmachung des Hinweises auf die Entscheidung über den Einspruch: **18.08.2004**
(45) Hinweis auf die Patenterteilung: 10.05.2000
(21) Anmeldenummer: 96115273.3
(22) Anmeldetag: 24.09.1996
(51) Int. Cl.: G03F 1/00, G03F 7/095

(54) **Verfahren zur Herstellung von Flexodruckplatten unter Verwendung eines durch digitale Informationsübertragung geeigneten mehrschichtigen Aufzeichnungselements**
Process for manufacturing a flexographic printing plate using a multilayer recording element suitable for the production of flexographic printing plates by digital information transmission
Procédé pour la fabrication d'une plaque d'impression flexographique utilisant un élément pour l'enregistrement multicouche utilisable pour la production des plaques d'impression flexographiques par transmission d'information digitale

(30) Priorität: 02.10.1995 DE 19536805
(43) Veröffentlichungstag der Anmeldung: 09.04.1997
(73) Patentinhaber: BASF Coatings Aktiengesellschaft, 48165 Münster (DE)
(72) Erfinder: Loerzer, Thomas, 76829 Landau (DE); Sandig, Hartmut, 67227 Frankenthal (DE); Goffing, Friedrich, 67117 Limburgerhof (DE); Leinenbach, Alfred, 67161 Gönnheim (DE); Nisslmüller, Hans-Jürgen, 67063 Ludwigshafen (DE)
(74) Vertreter: Paashaus, Sabine Dr.

(56) Entgegenhaltungen:
- EP-A- 0 720 057
- EP-A- 0 741 330
- WO-A-94/03838
- WO-A-94/03839
- WO-A-96/16356
- JP-A- 58 052 646
- US-A- 4 020 762
- US-A- 4 460 675
- US-A- 4 894 315
- PATENT ABSTRACTS OF JAPAN vol. 7, no. 138 (P-204), 16.Juni 1983 & JP-A-58 052646 (DAINIPPON INSATSU KK), 28.März 1983,
- PATENT ABSTRACTS OF JAPAN vol. 10, no. 190 (P-474), 4.Juli 1986 & JP-A-61 036750 (RICOH CO., LTD.), 21.Februar 1986,

## Beschreibung

Die Erfindung betrifft ein Verfahren zur Herstellung von Flexodruckplatten durch digitale Informationsübertragung bei dem geeignetes mehrschichtiges Aufzeichnungselement, das auf einem dimensionsstabilen Träger übereinander angeordnet eine, gegebenenfalls mit dem dimensions- . stabilen Träger durch eine Haftschicht verbundene, durch aktinische Strahlung vernetzbare Schicht, eine gegen IR-Strahlung empfindliche Schicht sowie gegebenenfalls eine abziehbare Deckfolie aufweist, eingesetzt wird.

Flexographische Druckformen bestehen aus einer lichtempfindlichen photopolymerisierbaren Schicht, die auf einem dimensionsstabilen Träger, wie z.B. einer Polyethylenterephthalatfolie oder auch einem Aluminiumblech, aufgebracht ist. Zwischen diesen Schichten kann noch eine Adhäsionsschicht appliziert sein, um den Verbund haftfest auszurüsten. Auf der lichtempfindlichen, photopolymerisierbaren Schicht kann sich außerdem noch eine Deckschicht befinden. Diese Deckschicht wird immer dann benötigt, wenn die darunterliegende lichtempfindliche, photopolymerisierbare Schicht so klebrig ist, daß beim Auflegen des photographischen Negativs die vorhandene Luft im Vakuumbelichtungsrahmen nicht gleichmäßig entfernt werden kann, was dann sogenannte Vakuumfehler beim Belichten zur Folge hätte.

Auf diese lichtempfindlichen, photopolymerisierbaren Schichten werden durch Auflegen eines photographischen Negativs, Entfernen der Luft mittels Vakuumrahmen und vollflächiges Belichten die im photographischen Negativ enthaltenen Informationen übertragen. Im anschließenden Entwicklungsschritt werden die nichtphotopolymerisierten Bereiche durch geeignete Entwickler entfernt; die photopolymerisierten Bildteile sind nicht löslich und bilden so die Reliefstruktur. Der Entwickler muß auf die verwendete photopolymerisierbare Schicht und gegebenenfalls auch auf die verwendete Deckschicht abgestimmt sein. Als geeignete Entwickler werden je nach Art des Bindemittels im allgemeinen Gemische aus Perchlorethylen mit Alkoholen, Gemische aus Kohlenwasserstoffen mit Alkoholen, reines Wasser oder auch Gemische aus Wasser und darin löslichen Bestandteilen, wie z.B. Soda, Natronlauge, Zitronenlauge, Milchsäure, Tenside usw. benutzt. Dem Entwicklungsschritt schließt sich ein Trocknungsschritt an, um den Entwickler aus der angequollenen Reliefschicht zu entfernen. Je nach lichtempfindlichem Material kann die Platte noch weitere Verarbeitungsschritte benötigen. So ist bei manchen Druckformen noch eine vollflächige Nachbelichtung erforderlich, um die Druckform vollständig auszuhärten. Auch können z.B. bei Druckformen auf Basis von Styrol-Butadien (Isopren)-Blockcopolymeren die Oberflächen durch eine UVC-Nachbehandlung entklebt werden.

Bei dem hier geschilderten Verfahren wird die Information über ein photographisches Negativ übertragen. Nach dem Stand der Technik können photographische Negative durch Belichtung eines lichtempfindlichen Films mittels eines Plotters mit nachfolgender Entwicklung hergestellt werden. Die Information, die dabei auf den Film übertragen wird, entstammt heutzutage einem digitalisierten Datenbestand. Von daher wäre es wünschenswert, wenn eine Flexodruckform ohne den Umweg über ein photographisches Negativ hergestellt werden kann. Neben verkürzten Herstellzeiten würden die naßchemischen Prozesse bei der Filmentwicklung nicht mehr benötigt werden. Zudem können sich die geometrischen Maße eines photographischen Negativs durch Temperatur und Luftfeuchtigkeit ändern, was zu Registerproblemen der fertigen Flexodruckform führen kann, da beim Belichten einer entsprechenden lichtempfindlichen photopolymerisierbaren Schicht die Information des photographischen Negativs projizierend 1:1 übertragen wird.

Digitale Verfahren, bei denen kein photographisches Negativ benötigt wird, sind schon seit langem bekannt.

So wird in der US-A-4555471 ein Maskenfilm beschrieben, der direkt auf einer photopolymerisierbaren Platte aufgebracht sein kann. Durch eine Laserbelichtung läßt sich der Maskenfilm, der ein thermochromes System besitzt, in der optischen Dichte beeinflussen, und man kann auf diese Weise das Negativ erzeugen.

Auch in der EP 0001138-A 1 wird ein Verfahren zur Herstellung von lithographischen Druckplatten unter Bildung eines "fugitive negative" beschrieben.

In der DE 4117127 A 1 wird ein Verfahren beschrieben, bei dem eine Bildmaske auf lichtempfindlichen Aufzeichnungselementen durch Nutzung eines Tintenstrahldruckers oder eines elektrophotographischen Druckers, erzeugt wird. Nachteil ist hier, daß die Auflösung für den Hochqualitätsflexorasterdruck nicht ausreichend fein genug ist.

In der WO 94/03839 wird ein Verfahren beschrieben, bei dem mittels eines IR-Lasers ein lichtempfindliches Aufzeichnungselement strukturiert wird und auf diese Weise eine Bildmaske erzeugt wird. Das lichtempfindliche Aufzeichnungselement besteht hier aus einem Träger, einer lichtempfindlichen Schicht, einer IR-lichtempfindlichen Schicht, die für aktinisches Licht undurchlässig ist, und einer Folie. Bei der Belichtung mit dem IR-Laser werden die belichteten Stellen der IR-lichtempfindlichen Schicht an die darüberliegende Folie fixiert und können durch Abziehen der Folie mitentfernt werden. Man erhält so eine Bildmaske auf der lichtempfindlichen Aufzeichnungsschicht. Nachteilig ist hier, daß Beschädigungen, wie z.B. Kratzer, der Folie, die auch als mechanischer Schutz wirken soll, zu einer fehlerhaften Informationsübertragung führt.

In der US-A-5262275 wird ein Verfahren beschrieben, bei dem auch mittels IR-Laser Flexodruckformen digital bebildert werden. Das Aufzeichnungselement besteht aus einem Träger, einer lichtempfindlichen Schicht, einer Sperrschicht und einer IR-lichtempfindlichen Schicht, die für aktinisches Licht undurchlässig ist. Die IR-lichtempfindliche Schicht wird direkt mit dem IR-Laser beschrieben, wobei an den beschriebenen Stellen das IR-lichtempfindliche Material verdampft wird und damit an diesen Stellen für aktinisches Licht durchlässig wird. Die noch vorhandene Sperrschicht verbleibt auf der Oberfläche der photopolymerisierbaren Schicht.

Diese Sperrschicht soll verhindern, daß atmosphärischer Sauerstoff während der Photopolymerisation in die photopolymerisierbare Schicht eindringt und somit die Belichtungszeit erhöht. Weiterhin sollen auch die Ergebnisse des Belichtungsschrittes im Vergleich zu einem Aufzeichnungselement, bei dem diese Sperrschicht fehlt, besser reproduzierbar sein.

JP-A 5852646 beschreibt Aufzeichnungselemente zur Herstellung von Druckplatten, die aus einem Substrat, einer gegen aktinische Strahlung empfindlichen Schicht und einer gegen Laserstrahlung empfindlichen Schicht bestehen. Die gegen Laserstrahlung empfindliche Schicht wird aus Silbersalzemulgatoren oder durch Aufdampfen von Metall filmen wie von Kupfer, Nickel oder Chrom gebildet. Zunächst werden bildmäßig die gewünschten Teile der laserempfindlichen Schicht mit Hilfe eines Lasers entfernt, anschließend wird unter Ausnutzung der oberen Schicht als Maske die untere, gegen aktinische Strahlung empfindliche Schicht belichtet, und schließlich wird mit einem Entwickler ausgewaschen.

Aufgabe der vorliegenden Erfindung ist es, ein Verfahren zur Herstellung von Flexodruckplatten durch digitale Informationsübertragung aufzuzeigen, das sich durch geringere Tonwertzunahme beim Drucken auszeichnet. Überraschenderweise läßt sich dies durch den erfindungsgemäßen Schichtaufbau erreichen.

Gegenstand der vorliegenden Erfindung ist auch ein Verfahren zur Herstellung von Flexodruckplatten, gemäß Anspruch 1.

Das erfindungsgemäße Verfahren ist hervorragend für die digitale Informationsübertragung geeignet.

Als dimensionsstabile Träger kommen die für die Flexodruckplattenherstellung üblichen in Frage.

Beispiele geeigneter dimensionsstabiler Träger sind Platten, Folien und konische und zylindrische Röhren (sleeves) aus Metallen wie Stahl, Aluminium, Kupfer oder Nickel oder aus Kunststoffen wie Polyethylenterephthalat, Polybutylenterephthalat, Polyamid und Polycarbonat, Gewebe und Vliese, wie Glasfasergewebe sowie Verbundmaterialien aus Glasfasern und Kunststoffen.

Als dimensionsstabile Träger kommen insbesondere dimensionsstabile Trägerfolien, beispielsweise Polyethylen- oder Polyesterfolien, insbesondere Polyethylenterephthalatfolien in Frage. Diese Trägerfolien sind im allgemeinen zwischen 50 und 500 µm, vorzugsweise 75 bis 400 µm, beispielsweise ca. 125 µm dick.

Diese Trägerfolien können mit einer dünnen haftvermittelnden Schicht, beispielsweise einer 1 bis 5 µm dicken Schicht auf der der lichtempfindlichen Aufzeichnungsschicht zugewandten Seite der Trägerfolie beschichtet sein. Diese Haftschicht kann beispielsweise aus einem Gemisch'aus einem Polycarbonat, einem Phenoxyharz und einem multifunktionellen Isocyanat bestehen.

Bei der durch aktinische Strahlung vernetzbaren Schicht (A) handelt es sich erfindungsgemäß um eine Schicht, die im wesentlichen aus einem Gemisch aus mindestens einem elastomeren Bindemittel, einer oder mehrerer ethylenisch ungesättigten copolymerisierbaren organischen Verbindung, einem Photoinitiator oder einem Photoinitiatorsystem sowie gegebenenfalls weiteren Hilfsstoffen besteht und nach bildmäßiger Belichtung durch einen organischen Entwickler auswaschbar ist.

Als elastomere Bindemittel eignen sich beispielsweise elastomere polymere Bindemittel, wie z.B. Polyalkandiene, Vinylaromat/Alkadien-Copolymerisate und -Blockpolymerisate, AlkadienlAcrylnitril-Copolymerisate, Ethylen/-Propylen-Copolymerisate, Ethylen/Propylen/Alkadien-Copolymerisate, Ethylen/Acrylsäure-Copolymerisate, Alkadien/Acrylsäure-Copolymerisate, Alkadien/Acrylat/Acrylsäure-Copolymerisate und Ethylen/(Meth)Acrylsäure/(Meth)Acrylat-Copolymerisate.

Ganz besonders gut geeignet sind Elastomere, welche konjugierte Alkadiene wie Butadien oder Isopren und Styrol einpolymerisiert enthalten.

Das elastomere Bindemittel ist in der photopolymerisierbaren Schicht (A) in einer Menge von 50 bis 95, vorzugsweise 50 bis 90 Gew.-%, bezogen auf die Gesamtmenge der in (A) enthaltenen Komponenten enthalten.

Des weiteren enthält die erfindungsgemäß zu verwendende photopolymerisierbare reliefbildende Aufzeichnungsschicht (A) übliche und bekannte copolymerisierbare ethylenisch ungesättigte organische Verbindungen, welche mit den polymeren Bindemitteln verträglich sind, in einer Menge von 1 bis 60, vorteilhafterweise von 2 bis 50, und insbesondere von 3 bis 40 Gew.-%, bezogen auf die Gesamtmenge von (A). Die Bezeichnung "verträglich" zeigt an, daß die betreffenden Monomere mit dem elastomeren Bindemittel so gut abmischbar sind, daß in der betreffenden photopolymerisierbaren reliefbildenden Aufzeichnungsschicht (A) keine Trübungen oder Schlieren hervorgerufen werden. Beispiele geeigneter Monomerer sind die üblichen und bekannten Acrylate und Methacrylate von ein- oder mehrwertigen Alkoholen, Acryl- und Methacrylamide, Vinylether und Vinylester, Allylether und Allylester sowie Fumar- oder Maleinsäurediester, insbesondere die Ester der Acryl- und/ oder Methacrylsäure mit ein- und vorzugsweise mehrwertigen Alkoholen, wie z.B. Ester der Acryl- oder Methacrylsäure mit Äthandiol, Propandiol, Butandiol, Hexandiol, Oxaalkandiolen, wie z.B. Diethylenglykol, oder Ester der Acryl- oder Methacrylsäure mit drei- oder mehrwertigen Alkoholen, wie z.B. Glycerin, Trimethylolpropan, Pentaerythrit oder Sorbit. Beispiele für besonders geeignete mono- und polyfunktionelle Acrylate oder Methacrylate sind Butylacrylat, Butylmethacrylat, 2-Ethylhexylacrylat, Lauryl(meth)acrylat, Hexandioldiacrylat, Hexandioldimethacrylat, Ethylenglykol-di(meth)acrylat, Butandiol-1,4-di(meth)acrylat, Neopentylglykol-di(meth)acrylat, 3-Methylpentandiol-di(meth)acrylat, 2-Hydroxipropyl(meth)acrylat, 2-Hydroxiethyl(meth)acrylat, 1,1,1-Trimethylolpropantri(meth)acrylat, Di-, Tri- und Tetraethylenglykoldi(meth)acrylat, Tripropylenglykoldi(meth) acrylat oder Pentaerythrit-tetra(meth)acrylat, des weiteren Poly(ethylenoxid)di(meth)acrylat, ω-Methylpoly( ethylenoxid)-α-yl-(meth)acrylat, N,N-Diethylaminoethylacrylat, ein Umsetzungsprodukt aus 1 mol Glycerin, 1 mol Epichlorhydrin und 3 mol Acrylsäure sowie Glycidylmethacrylat und Bisphenol-A-diglycidetheracrylat.

Es eignen sich auch Gemische photopolymerisierbarer ethylenisch ungesättigter organischer Verbindungen, sowie z.B. Gemische monofunktioneller (Meth)acrylate, wie z.B. Hydroxiethylmethacrylat mit polyfunktionellen (Meth) acrylaten der oben angeführten Art.

Außer den (Meth)acrylsäureestern eignen sich auch Derivate von (Meth)acrylsäureamiden, wie z.B. N-Methylol-(meth)acrylamidether von Polyolen (z.B. Glykol).

Neben elastomerem Bindemittel und copolymerisierbaren ethylenisch ungesättigten monomeren Verbindungen enthält die durch aktinische Strahlung vernetzbare Schicht (A) (= lichtempfindliche Aufzeichnungsschicht(A)) einen oder mehrere Photoinitiatoren, wie z.B. Benzoin oder Benzoinderivate, wie Benzoinether geradkettiger oder verzweigter Monoalkohole mit 1 bis 6 Kohlenstoffatomen, z.B. Benzoinmethyl-, -ethyl-, -isopropyl-, -n-butyl-, -isobutylether, symmetrisch oder unsymmetrisch substituierte Benzilacetale, wie Benzildimethylacetal, Benzil-1-methyl-1-ethylacetal, Diarylphosphinoxide, wie z.B. 2,4,6-Trimethylbenzoyldiphenylphosphinoxid oder 2,6-Dimethoxybenzoyldiphenylphosphinoxid oder Acryldiarylphosphinoxide gemäß DE-OS 29 09 992, oder Hydroxipropanone wie 1-Phenyl-2-methyl-2-hydroxi-1-propanon und 1-Hydroxicyclohexylphenylketon. Sie können allein oder im Gemisch miteinander oder in Verbindung mit Coinitiatoren verwendet werden, z.B. Benzoinmethylether mit Triphenylphosphin, Diacylphosphinoxide mit tertiären Aminen oder Acyldiarylphosphinoxide mit Benzildimethylacetal.

In den Gemischen werden sie in einer Menge von 0,001 bis 10, vorteilhaft 0,1 bis 5 und insbesondere 0,3 bis 2 Gew.-%, bezogen auf die Gesamtmenge der lichtempfindlichen Aufzeichnungsschicht (A), verwendet, wobei die Menge mitbestimmt wird von der Mitverwendung photopolymerisierbarer Monomerer.

Als gegebenenfalls mitzuverwendende weitere Hilfsstoffe können - im allgemeinen in einer Menge von 0,001 bis 2 Gew.-%, bezogen auf die Gesamtmenge der lichtempfindlichen Aufzeichnungsschicht (A) - Inhibitoren gegen die thermische Polymerisation, die keine nennenswerte Eigenabsorption in dem aktinischen Bereich, in dem der Photoinitiator absorbiert, aufweisen, zugesetzt werden, wie z.B. 2,6-D-tert.-butyl-p-kresol, Hydrochinon, p-Methoxiphenol, β-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosamine, wie N-Nitrosodiphenylamin, oder die Salze, beispielsweise die Kalium-, Calcium- oder Aluminiumsalze, des N-Nitrosocyclohexylhydroxylamins.

Auch geeignete Farbstoffe, Pigmente oder photochrome Zusätze können dem lichtempfindlichen Gemisch der Aufzeichnungsschicht (A) in einer Menge von 0,0001 bis 2 Gew.-%, bezogen auf das Gemisch, zugesetzt werden. Sie dienen der Steuerung der Belichtungseigenschaften, der Identifizierung, der direkten Kontrolle des Belichtungsergebnisses oder ästhetischen Zwecken. Voraussetzung für die Auswahl und die Menge solcher Zusätze ist, daß sie ebenso wenig wie die Inhibitoren der thermisch initiierten Polymerisation die Photopolymerisation der Gemische stören. Geeignet sind z.B. die löslichen Phenazinium-, Phenoxazinium-, Acridinium- und Phenothiaziniumfarbstoffe, wie Neutralrot (C.I. 50040), Safranin T (C.I. 50240), Rhodanilblau, dem Salz bzw. Amid aus Rhodamin D (Basic Violett 10), Rhodanilblau, dem Salz bzw. Amid aus Rhodamin D (Basic Violett 10, C.I. 45170), Methylenblau B (C.I. 52015), Thioninblau G (C.I. 52025), Thioninblau G (C.I. 52025) oder Acridinorange (C.I. 46005); sowie auch Solvent Black 3 (C.I. 26150). Diese Farbstoffe können auch zusammen mit einer hinreichenden Menge eines Reduktionsmittels verwendet werden, welches den Farbstoff in Abwesenheit von aktinischem Licht nicht reduziert, bei Belichtung jedoch den Farbstoff im angeregten Elektronenzustand reduzieren kann. Beispiele solchermilden Reduktionsmittel sind Ascorbinsäure Anethol, Thioharnstoff, z.B. Diethylallylthioharnstoff, insbesondere N-Allylthioharnstoff, sowie Hydroxylaminderivate, insbesondere Salze des N-Nitrosocyclohexyl-hydroxylamins, vorzugsweise die Kalium-, Calcium- und Aluminiumsalze. Letztere können, wie erwähnt, zugleich als Inhibitoren der thermisch initiierten Polymerisation dienen. Die Reduktionsmittel können im allgemeinen in Mengen von 0,005 bis 5 Gew.-%, bezogen auf das Gemisch, zugesetzt werden, wobei sich in vielen Fällen der Zusatz eines 3- bis 10fachen der Menge an mitverwendetem Farbstoff bewährt hat. Zusätzlich können die Rezepturen noch in Mengen von 1 bis 20, vorzugsweise 3 bis 10 Gew.-% Basen enthalten, die die Säurefunktionen des Ethylen-Acrylsäure-Copolymers teilweise oder vollständig neutralisieren. Gut geeignete Basen sind beispielsweise Alkalihydroxide, Alkalialkoholate, sowie Amine und Alkanolamine. Besonders gut geeignete Basen sind Monoethanolamin, Diethanolamin, Butylethanolamin und Triethanolamin.

Die Herstellung der erfindungsgemäß zu verwendenden photopolymerisierbaren reliefbildenden Aufzeichnungsschicht (A) aus ihren Bestandteilen erfolgt im allgemeinen durch Mischen der Bestandteile mit Hilfe bekannter Mischmethoden und durch Verarbeiten der Mischung zur Aufzeichnungsschicht (B) mit Hilfe bekannter Techniken, wie Gießen aus Lösung, Kalandrieren oder Extrudieren, wobei diese Maßnahmen auch in geeigneter Weise miteinander kombiniert werden können.

Die durch aktinische Strahlung vernetzbare Schicht (A) weist im allgemeinen eine Dicke von 200 bis 8000, insbesondere 500 bis 6000 µm auf. Auf ihr kann eine weitere dünne sauerstoffdurchlässige Schicht, die eine Dicke zwischen 1 und 5 µm aufweisen kann, angebracht sein, die die Oberfläche der lichtempfindlichen Aufzeichnungsschicht (A) entklebt. Auf letzterer oder vorzugsweise direkt auf der durch aktinische Strahlung vernetzbaren Schicht (A) ist die IR ablative Schicht (B) angebracht, die eine in Entwickler lösliche oder dispergierbare Schicht ist, die in einem filmbildenden Bindemittel mit elastomerem Charakter mindestens eine feinverteilte Substanz enthält, die eine hohe Absorption im Wellenlängenbereich zwischen 750 und 20 000 nm und im aktinischen Bereich eine optische Dichte ≥ 2,5 aufweist. Entwickler können dabei Wasser und Wasser/Alkohol bzw. organische Lösungsmittel (gemische) sein NL, BE: Als Bindemittel mit elastomeren Charakter eignen sich für die Schicht (B) Polymerisate, insbesondere Copolymerisate, die entweder wasserlöslich bzw. in Wasser oder Wasser/Alkohol-Gemischen dispergierbar sind. Als Alkohole in den Wasser/Alkohol-Gemischen kommen Methanol, Ethanol, n-Propanol und Isopropanol in Betracht.

Beispiele für in Wasser bzw. in Wasser/Alkohol-Gemischen lösliche bzw. dispergierbare Bindemittel mit elastomerem Charakter sind Polyvinylalkohol/Polyethylenglykol-Graft-Copolymere (z.B. Mowiol® GE 597 der Fa. Hoechst), die durch Pfropfen von Vinylacetat auf Polyethylenglykol mit Molekulargewichten zwischen 1000 und 50000 und anschließender Verseifung bis zu einem Verseifungsgrad zwischen 80 und 100 % erhältlich sind.

Als Bindemittel mit elastomerem Charackter für die Schicht (B) wird ein Polyvinylalkohol/ Polyethylenglykol - Graft-Copolymer eingesetzt.

Die filmbildenden Bindemittel mit elastomeren Charakter der Schicht (B) enthalten feinverteilt Substanzen, die eine hohe Absorption im IR aufweisen. Beispiele derartiger Substanzen sind verschiedene feinteilige Rußarten z. B. Farbruß FW 2000, Spezialschwarz 5, Printex®U der Fa. Degussa mit einer mittleren Primärteilchengröße von 13 - 30 nm. Vorteilhafterweise verwendet man Lösungen, die Bindemittel mit elastomerem Charakter und Substanzen mit hoher IR-Absorption aufweisen, die entweder direkt auf die Schicht (A) gleichmäßig aufgetragen und getrocknet oder auf eine Folie gegossen, getrocknet und auf die Schicht (A) aufkaschiert werden. Die Folie kann gegebenenfalls abgezogen werden.

Es kann auch noch eine für aktinisches Licht transparente abziehbare Folie, eine Deckfolie, die eine Dicke von 5 bis 300 µm, die beispielsweise aus Polyethylen oder Polyethylenterephthalat besteht, auf der Schicht (B) angebracht sein.

Die Verarbeitungsschritte, die die Belichtung mit aktinischem Licht, Entwickeln und Trocknen umfassen, sind ausführlich z.B. in der nyloflex®-Arbeitsanleitung (IIR 340705/1185) der BASF Aktiengesellschaft beschrieben.

Die IR ablative Schicht (B) läßt sich mit einem IR-Laser, vorzugsweise mit einem Nd-YAG-Laser, bildmäßig beschreiben. Dies kann zweckmäßigerweise auf einer Trommel erfolgen, auf der die Platte montiert ist. Als vorteilhaft erweist sich hierbei eine IR-ablative Schicht (B), die aus einem elastomeren Bindemittel und darin dispergierten IR-Absorbern besteht. Durch den elastomeren Charakter dieser Schicht wird die Oberfläche der Platte, die durch die Montage auf die Trommel gelängt ist, nicht beschädigt wie es bei einem nicht-elastischen Material der Fall wäre. Nach der digitalen Informationsübertragung erfolgt eine vollflächige Belichtung mit aktinischem Licht. Dies kann entweder auf der Trommel des IR-Lasers geschehen, oder man demontiert die Platte und führt die vollflächige Belichtung in einem konventionellen Flachbelichter (z.B. FIII-Belichter der Fa. BASF) durch. Anschließend wird das Aufzeichnungselement entwickelt. Dazu kann man handelsübliche Durchlauf- oder Rundwascher benutzen, wie sie z.B. von BASF Aktiengesellschaft angeboten werden. Entsprechend der Chemie des eingesetzten Bindemittels mit elastomerem Charakter der Schicht (B) muß diese Schicht gegebenenfalls in einem Vorentwickler entfernt werden, wenn diese Schicht in dem Entwickler der Schicht (A) nicht löslich oder dispergierbar ist. So haben sich folgende Entwicklerkombinationen in Abhängigkeit von der Chemie der Schicht(B) als vorteilhaft erwiesen:

| Bindemittel der Schicht (B): | Löslichkeit der Schicht (A) | Entwickler für Schicht (B) |
|---|---|---|
| Polyvinylalkohol/Polyethylenglykol-Graft-Copolymer | organisches Lösungsmittel oder Gemische organischer Lösungsmittel | Wasser oder Wasser/Alkohol |

Als Entwickler geeignete organische Lösungsmittelgemische sind z.B. Perchlorethylen/Butanol-Gemische oder Nylosolv® (Kohlenwasserstoff/Alkohol-Gemisch).

Der Vorentwicklungsschritt kann sehr einfach, beispielsweise in handelsüblichen Plüschwaschern der Firma BASF durchgeführt werden, die hierfür hervorragend geeignet sind.

Nach dem Entwickeln wird das Aufzeichnungsmaterial noch einem Trocknungsschritt unterworfen. Hierbei wird der noch in der Reliefschicht enthaltene Entwickler entfernt. Auch hier sind alle handelsüblichen Trockner, wie z. B. auch die der BASF A.G., geeignet.

Bei der vollflächigen Belichtung mit aktinischem Licht erweist sich die Gegenwart von atmosphärischem Sauerstoff überraschenderweise als überaus vorteilhaft.

Durch den Sauerstoff, der bekanntlich als Inhibitor der Photopolymerisation wirkt, wird an den Rändern der Bildbereiche - das sind später die druckenden Bereiche - die Photopolymerisation unterdrückt; in der Mitte der Bildbereiche ist der inhibierende Einfluß nicht so stark, da genügend aktinisches Licht zur Verfügung steht. So kommt es, daß der Durchmesser eines jeden Bildetementes deutlich reduziert ist. Mit anderen Worten erhält man keine 1:1-Übertragung von derdurch IR-Ablation erzeugten Maske sondern eine flächenmäßig geringere Übertragung. Dies hat beim Drucken den großen Vorteil, daß man eine viele geringere Tonwertzunahme erzielt. Dies ist von großem Vorteil, da beim Flexodruckverfahren die Druckplatte über eine Rasterwalze eingefärbt wird, die Farbe dann von der Druckplatte auf den Bedruckstoff übertragen wird, wobei der Bedruckstoff um eine harte Gegenwalze geführt wird. Hierbei wird die elastische Flexodruckplatte zusammengedrückt, was zur Folge hat, daß durch diesen Quetschvorgang die bedruckte Fläche größer ist als die eingefärbte Fläche auf der Druckplatte. Man spricht in diesem Zusammenhang von Tonwertzunahme. Benutzt man die in US-A-5 262 275 beschriebenen lichtempfindlichen Aufzeichnungsmaterialien mit Sperrschicht zwischen IR-empfindlicher Schicht und durch aktinisches Licht vernetzbarer Schicht, so kommt der inhibierende Einfluß des atmosphärischen Sauerstoffs lange nicht so stark zur Geltung; entsprechend höher ist dann auch die Tonwertzunahme einer so gefertigten Druckplatte im Druckprozeß.

Die Beispiele zeigen die Herstellung der erfindungsgemäßen lichtempfindlichen Aufzeichnungselemente sowie die mit diesen Aufzeichnungselementen erzielten Druckergebnisse. Die in den Beispielen genannten Teile und Prozente sind, soweit nicht anders angegeben, Gewichtsteile und Gewichtsprozente.

### Vergleichsbeispiel 1 :

Entsprechend Beispiel 2 aus US 5 262 275 wurde eine lichtempfindliche Aufzeichnungsschicht gefertigt. Dieses lichtempfindliche Aufzeichnungsmaterial wurde auf eine Vakuumtrommel montiert und mittels eines Nd:YAG-Lasers (Wellenlänge 1064 nm) belichtet. Der Spotdurchmesser des IR-Laserstrahls war auf 10 µm eingestellt. Es handelt sich hierbei um einen Belichter der Fa. Baasel-Scheel. Anschließend wurde die Platte von der Trommel demontiert und in einem FIII-Belichter (von BASF) 15 Minuten lang vollflächig belichtet. Danach wurde die Platte in einem BASF-Rundwascher mit einem 3:1-Gemisch aus Perchlorethylen/Butanol entwickelt und anschließend 2 Stunden bei 60°C getrocknet. Das gewählte Druckmotiv wies eine Rasterweite von 54 L/cm auf und hatte einen Tonwertumfang von 3 - 95 %. Dann wurde diese Flexodruckplatte auf einer handelsüblichen Flexodruckmaschine montiert, und Polyethylen-Folie mit Alkoholfarben bedruckt. Anschließend wurde das Druckergebnis visuell bewertet im Vergleich zu den Beispielen 1 und 2.

### Beispiel 1:

Eine wasserlösliche, IR-ablative Schicht (B) wurde durch Lösen von 3 Teilen Ruß (Printex U der Fa. Degussa), 4 Teilen eines Polyvinylalkohol-polyethylenglykol-Graft-Copolymeren (Mowiol GE 597 der Fa. Hoechst) der durch Pfropfen von Vinylacetat auf Polyethylenglykol mit anschließender Verseifung erhalten wurde, in 80 Teilen Wasser und 10 Teilen Propanol hergestellt. Propanol als Cosolvens wurde benutzt, um beim Gießen dieser Lösung auf eine Polyethylenterephthalatfolie eine gute Benetzung zu erreichen. Nach Zusammenbringen dieser Bestandteile wurde die Dispersion 2 Stunden in einem Dispergator (Ultra-Turrax) behandelt, um eine feinteilige Dispersion zu erhalten. Die so hergestellte Dispersion wurde auf eine Polyethylenterephthalatfolie (125 µm Mylar® der Fa. DuPont) gegossen und zwar derart, daß die Schichtdicke nach dem Trocknen 5 µm betrug und die optische Dichte dieser Schicht bei 4 bis 4,5 liegt.

Dieser Verbund wurde auf eine Mehrschichtplatte, die in der Schicht (A) als elastomeres Bindemittel ein Styrol/Isopren-Blockcopolymerisat enthält und mit organischen Lösungsmitteln entwickelbar ist, (z.B. eine Cyrel®107 PLS+Druckplatte - von Fa. DuPont) in üblicher Weise aufkaschiert, nachdem man bei dieser Platte die Schutzfolie und die darunterliegende Deckschicht (= Sperrschicht) durch Abziehen entfernt hatte.

Nach Abziehen der Schutzfolie wurde dieses lichtempfindliche Aufzeichnungsmaterial auf eine Vakuumtrommel montiert und mittels eines Nd:YAG-Lasers (Wellenlänge 1064 nm) belichtet. Der Spotdurchmesser des IR-Laserstrahls war auf 10 µm eingestellt. Es handelt sich hierbei um einen Belichter der Fa. Baasel-Scheel. Anschließend wurde die Platte von der Trommel demontiert und in einem FIII-Belichter (von BASF) 15 Minuten lang vollflächig belichtet. Danach wurde die Platte in einem BASF-Rundwascher mit einem 3:1-Gemisch aus Perchlorethylen/Butanol entwickelt und anschließend 2 Stunden bei 60°C getrocknet. Das gewählte Druckmotiv entsprach dem vom Vergleichsbeispiel 1. Dann wurde diese Flexodruckplatte auf einer handelsüblichen Flexodruckmaschine montiert, und es wurde Polyethylen-Folie mit Alkoholfarben bedruckt. Anschließend wurde das Druckergebnis visuell bewertet. Der di- ' rekte Vergleich mit Vergleichsbeispiel 1 machte eindrucksvoll deutlich, daß die Tonwertzunahme bei dem Beispiel 1 sehr viel geringer ausfällt; die feinen Bildelemente zeigen einen viel feineren Ausdruck. Insgesamt ist das Druckergebnis gemäß Beispiel 1 in allen Belangen deutlich besser als das von Vergleichsbeispiel 1.

### Beispiel 2:

Es wurde die IR-ablative Schicht wie in Beispiel 1 auf eine 125 µm-Mylar-Folie appliziert. Dann wurde die lichtempfindliche Polymerschicht direkt zwischen der mit einem Haftlack versehenen Trägerfolie und der mit der IR-lichtempfindlichen Schicht (B) versehenen Mylar-Folie zusammen extrudiert. Das dabei eingesetzte photopolymerisierbare Material (= Schicht (A)) besteht zu 80 Teilen aus Cariflex TR 1107 (Styrol-Isopren-Styrol-Blockcopolymer mit 15 % Styrol der Fa. Shell) als elastomerem Bindemittel, 10 Teilen Hexandioldiacrylat als Vernetzer, 1 Teil Benzildimethylketal als Photoinitiator, 1 Teil 2,6-Di-tert.-butyl-p-kresol als Stabilisator, 1 Teil eines mikrokristallinen Wachses (Antilux A 550 der Fa. Rheinchemie) als Ozonschutzmittel und 8 Teilen Weißöl. Der Extrusionsprozeß ist ausführlich in DE-A-3147325 (EP 80665) beschrieben.

Nach Abziehen der Schutzfolie wurde dieses lichtempfindliche Aufzeichnungsmaterial auf eine Vakuumtrommel montiert und mittels eines Nd:YAG-Lasers (Wellenlänge 1064 nm) belichtet. Der Spotdurchmesser des IR-Laserstrahls war auf 10 µm eingestellt. Hierzu wurde ein Belichter der Fa. Baasel-Scheel verwendet. Anschließend wurde die Platte von der Trommel demontiert und in einem FIII-Belichter (von BASF) 15 Minuten lang vollflächig belichtet. Danach wurde die Platte in einem BASF-Rundwascher mit einem 3: 1-Gemisch aus Perchlorethylen/Butanol entwickelt und anschließend 2 Stunden bei 60°C getrocknet. Das gewählte Druckmotiv entsprach dem vom Vergleichsbeispiel 1. Dann wurde diese Flexodruckplatte auf einer handelsüblichen Flexodruckmaschine montiert, und es wurde Polyethylen-Folie mit Alkoholfarben bedruckt. Anschließend wurde das Druckergebnis visuell bewertet. Der direkte Vergleich mit Vergleichsbeispiel 1 und Beispiel 1 machte deutlich, daß die Tonwertzunahme mit Beispiel 1 vergleichbar ist; die feinen Bildelemente zeigen einen sehr feinen Ausdruck. Insgesamt ist auch das Druckergebnis gemäß Beispiel 2 in allen Belangen deutlich besser als das von Vergleichsbeispiel 1.

## Patentansprüche (Patentansprüche für folgende(n) Vertragsstaat(en): DE, FR, GB, IT)

1. Verfahren zur Herstellung von Flexodruckplatten, dadurch gekenntzeichnet, dass mit einem IR-Laser die IR-ablative Schicht (B) eines mehrschichtigen Aufzeichnungselementes umfassend übereinander angeordnet,
- einen dimensionsstabilen Träger,
- optional eine Haftschicht,
- eine durch aktinische Strahlung vernetzbare Schicht (A) aus mindestens einem elastomeren Bindemittel, ethylenisch ungesättigten copolymerisierbaren organischen Verbindungen, einem Photoinitiator oder Photoinitiatorsystem, sowie optional weiteren Hilfsstoffen,
- eine IR-ablative Schicht (B), sowie
- optional eine abziehbare Deckfolie,
wobei Schicht (B) direkt auf Schicht (A) aufgebracht ist,
oder
auf Schicht (A) eine sauerstoffdurchlässige Schicht mit einer Dicke zwischen 1 und 5 µm aufgebracht ist, auf der Schicht (B) aufgebracht ist,
**dadurch gekennzeichnet,**
**dass** die IR-ablative Schicht (B) in Wasser oder einem Wasser/Alkohol-Gemisch löslich oder dispergierbar ist, im aktinischen Bereich eine optische Dichte ≥ 2,5 aufweist und in einem Polyvinylalkohol/Polyethylenglykol-Graft-Copolymer mindestens eine fein verteilte Substanz enthält, die eine hohe Absorption im Wellenlängenbereich zwischen 750 nm und 20000 nm hat, und
**dass** die durch aktinische Strahlung vernetzbare Schicht (A) nach bildmäßiger Belichtung mit einem organischen Lösungsmittel als Entwickler entwickelbar ist,
aus einem digitalen Datenbestand mittels IR-Ablation bildmäßig strukturiert wird und so eine Maske auf der darunterliegenden Schicht (A) erzeugt wird, anschließend die Schicht (A) durch vollflächige Belichtung in Gegenwart von atmosphärischem Sauerstoff mit aktinischer Strahlung in den später druckenden Bereichen vernetzt wird, und danach die Reste der Schicht (B) in Wasser oder Wasser/Alkohol-Gemischen dispergiert oder gelöst werden, und mit einem organischen Lösemittel als Entwickler die nicht vernetzten Bildteile der Schicht (A) ausgewaschen werden.

## Patentansprüche (Patentansprüche für folgende(n) Vertragsstaat(en): NL, BE)

1. Verfahren zur Herstellung von Flexodruckplatten, **dadurch gekennzeichnet, dass** mit einem IR-Laser die IR-ablative Schicht (B) des mehrschichtigen Aufzeichnungselementes umfassend übereinander angeordnet,
- einen dimensionsstabilen Träger,
- optional eine Haftschicht,
- eine durch aktinische Strahlung vernetzbare Schicht (A) aus mindestens einem elastomeren Bindemittel, ethylenisch ungesättigten copolymerisierbaren organischen verbindungen, einem Photoinitiator oder Photoinitiatorsystem, sowie optional weiteren Hilfsstoffen,
- eine IR-ablative Schicht (B), sowie
- optional eine abziehbare Deckfolie,
wobei Schicht (B) direkt auf Schicht (A) aufgebracht ist,
oder
auf Schicht (A) eine sauerstoffdurchlässige Schicht mit einer Dicke zwischen 1 und 5 µm aufgebracht ist, auf der Schicht (B) aufgebracht ist,
**dadurch gekennzeichnet,**
**dass** die IR-ablative Schicht (B) in Wasser oder einem Wasser/Alkohol-Gemisch löslich oder dispergierbar ist, im aktinischen Bereich eine optische Dichte ≥ 2,5 aufweist und in einem filmbildenden Bindemittel mit elastomerem Charakter mindestens eine fein verteilte Substanz enthält, die eine hohe Absorption im Wellenlängenbereich zwischen 750 nm und 20000 nm hat, und
**dass** die durch aktinische Strahlung vernetzbare Schicht (A) nach bildmäßiger Belichtung mit einem organischen Lösungsmittel als Entwickler entwickelbar ist,
aus einem digitalen Datenbestand mittels IR-Ablation bildmäßig strukturiert wird und so eine Maske auf der darunterliegenden Schicht (A) erzeugt wird, anschließend die Schicht (A) durch vollflächige Belichtung in Gegenwart von atmosphärischem Sauerstoff mit aktinischer Strahlung in den später druckenden Bereichen vernetzt wird, und danach die Reste der Schicht (B) in Wasser oder Wasser/ Alkohol-Gemischen dispergiert oder gelöst werden, und mit einem organischen Lösemittel als Entwickler die nicht vernetzten Bildteile der Schicht (A) ausgewaschen werden.

## Claims (Claims for the following Contracting State(s): DE, FR, GB, IT)

1. A process for the production of flexographic printing plates, wherein the layer (B) of a multilayer recording element comprising, arranged one on top of the other,
- a dimensionally stable substrate,
- optionally an adhesion-promoting layer,
- a layer (A) which is crosslinkable by actinic radiation and comprises at least one elastomeric binder, ethylenically unsaturated copolymerizable organic compounds, a photoinitiator or photoinitiator system and optionally further assistants,
- an IR-ablative layer (B), and
- optionally a peelable cover sheet,
wherein layer (B) has been applied directly layer (A),
or
to an oxygen-permeable layer from 1 to 5 µm in thickness which has been applied to layer (A),
**characterized in that**
the IR-ablative layer (B) is soluble or dispersible in water or a water/alcohol mixture, has an optical density of ≥ 2.5 in the actinic range and contains, in a polyvinyl alcohol/polyethylene glycol graft copolymer, at least one finely divided substance which has a high absorance in the wavelength range from 750 to 20,000 nm, and **in that**
the layer (A) which is crosslinkable by actinic radiation can be developed after imagewise exposure, using an organic solvent as developer,
which layer (B) is sensitive to IR radiation, is structured imagewise by means of an IR laser from a digital dataset and a mask is thus produced on the layer (A) underneath, the layer (A) is then crosslinked by uniform exposure to actinic radiation in the subsequently printing parts, and thereafter the residues of the layer (B) are dispersed or dissolved in water or water/alcohol mixtures and the uncrosslinked image sections of the layer (A) are washed out with an organic solvent as developer.

## Claims (Claims for the following Contracting State(s): NL, BE)

1. A process for the production of flexographic printing plates, wherein the layer (B) of a multilayer recording element comprising, arranged one on top of the other,
- a dimensionally stable substrate,
- optionally an adhesion-promoting layer,
- a layer (A) which is crosslinkable by actinic radiation and comprises at least one elastomeric binder, ethylenically unsaturated copolymerizable organic compounds, a photoinitiator or photoinitiator system and optionally further assistants,
- an IR-ablative layer (B), and
- optionally a peelable cover sheet,
wherein layer (B) has been applied directly to layer (A),
or
to an oxygen-permeable layer from 1 to 5 µm in thickness which has been applied to layer (A),
**characterized in that**
the layer (B) which is sensitive to IR radiation is soluble or dispersible in water or a water/alcohol mixture, has an optical density of ≥ 2.5 in the actinic range and contains, in a film-forming binder having elastomeric character, at least one finely divided substance which has a high absorance in the wavelength range from 750 to 20,000 nm, and **in that**
the layer (A) which is crosslinkable by actinic radiation can be developed after imagewise exposure, using an organic solvent as developer,
which layer (B) is sensitive to IR radiation, is structured imagewise by means of an IR laser from a digital dataset and a mask is thus produced on the layer (A) underneath, the layer (A) is then crosslinked by uniform exposure to actinic radiation in the subsequently printing parts, and thereafter the residues of the layer (B) are dispersed or dissolved in water or water/alcohol mixtures and the uncrosslinked image sections of the layer (A) are washed out with an organic solvent as developer.

## Revendications (Revendications pour l'(les) Etat(s) contractant(s) suivant(s): DE, FR, GB, IT)

1. Procédé pour la préparation de plaques flexographiques, **caractérisé par le fait qu'**on structure en forme d'image à partir d'un état de données numériques avec un laser IR la couche (B) sensible au rayonnement IR d'un élément d'enregistrement à plusieurs couches comportant, disposés l'un au-dessus de l'autre
- un support stable en dimensions,
- en option une couche d'adhérence,
- une couche (A) réticulable au moyen d'un rayonnement actinique, composée d'au moins un liant élastomère, des composés organiques copolymérisables à insaturation éthylénique, un photoinitiateur ou un système photoinitiateur, ainsi qu'en option d'autres adjuvants,
- une couche (B) ablative par IR, ainsi que
- en option une feuille de couverture pelable,
tandis qu'on place la couche (B) directement sur la couche (A),
ou
on place sur la couche (A) une couche perméable à l'oxygène ayant une épaisseur entre 1 et 5 m, sur laquelle on place la couche (B),
**caractérisé par le fait**
**que** la couche (B) ablative par IR est soluble ou dispersable dans l'eau ou dans un mélange d'eau/alcool, présente dans le domaine actinique une densité optique 2,5 et contient dans un copolymère greffé de poly(alcool vinylique)/polyéthylène-glycol au moins une substance finement divisée qui a une absorption élevée dans l'intervalle de longueurs d'onde entre 750 nm et 20000 nm, et
**que** la couche (A) réticulable par l'intermédiaire d'un rayonnement actinique peut être développée après illumination selon des images avec un solvant organique en tant que révélateur,
et on produit ainsi un masque sur la couche (A) sous-jacente, on réticule ensuite la couche (A) par illumination sur toute la surface avec un rayonnement actinique dans les domaines donnant ensuite une impression, et on disperse ou dissout ensuite les restes de la couche (B) dans l'eau ou dans des mélanges d'eau/alcool, et on élimine par lavage les parties d'image non-réticulées de la couche (A) avec un solvant organique comme révélateur.

## Revendications (Revendications pour l'(les) Etat(s) contractant(s) suivant(s): NL, BE)

1. Procédé pour la préparation de plaques flexographiques, **caractérisé par le fait qu'**on structure en forme d'image à partir d'un état de données numériques avec un laser IR la couche (B) sensible au rayonnement IR d'un élément d'enregistrement à plusieurs couches comportant, disposés l'un au-dessus de l'autre
- un support stable en dimensions,
- en option une couche d'adhérence,
- une couche (A) réticulable au moyen d'un rayonnement actinique, composée d'au moins un liant élastomère, des composés organiques copolymérisables à insaturation éthylénique, un photoinitiateur ou un système photoinitiateur, ainsi qu'en option d'autres adjuvants,
- une couche (B) ablative par IR, ainsi que
- en option une feuille de couverture pelable,
tandis qu'on place la couche (B) directement sur la couche (A),
ou
on place sur la couche (A) une couche perméable à l'oxygène ayant une épaisseur entre 1 et 5 m, sur laquelle on place la couche (B),
**caractérisé par le fait**
**que** la couche (B) sensible au rayonnement IR est soluble ou dispersable dans l'eau ou dans un mélange d'eau/alcool, présente dans le domaine actinique une densité optique 2,5 et contient dans un liant filmogène ayant un caractère élastomère au moins une substance finement divisée qui a une absorption élevée dans l'intervalle de longueurs d'onde entre 750 nm et 20000 nm, et
**que** la couche (A) réticulable par l'intermédiaire d'un rayonnement actinique peut être développée après illumination selon des images avec un solvant organique en tant que révélateur,
et on produit ainsi un masque sur la couche (A) sous-jacente, on réticule ensuite la couche (A) par illumination sur toute la surface avec un rayonnement actinique dans les domaines donnant ensuite une impression, et on disperse ou dissout ensuite les restes de la couche (B) dans l'eau ou dans des mélanges d'eau/alcool, et on élimine par lavage les parties d'image non-réticulées de la couche (A) avec un solvant organique comme révélateur.
